# EUROPEAN PATENT APPLICATION

(11) **EP 3 778 794 A1**
(43) Date of publication of application: **17.02.2021**
(21) Application number: 19776755.1
(22) Date of filing: 26.03.2019
(51) Int. Cl.: C09D 11/30, B41M 5/00, C09D 11/38, H05K 3/28

(54) **CURABLE COMPOSITION FOR INKJET PRINTING, CURED PRODUCT OF SAME, AND ELECTRONIC COMPONENT HAVING SAID CURED PRODUCT**

(30) Priority: 30.03.2018 JP 2018069210; 30.03.2018 JP 2018068960
(71) Applicant: Taiyo Ink Mfg. Co., Ltd., Hiki-gun, Saitama 355-0215 (JP)
(72) Inventor: WEI, Xiaozhu, Hiki-gun, Saitama 355-0215 (JP); YOSHIKAWA, Rina, Hiki-gun, Saitama 355-0215 (JP); ITO, Hideyuki, Hiki-gun, Saitama 355-0215 (JP); MATSUMOTO, Hiroshi, Hiki-gun, Saitama 355-0215 (JP); SHIMURA, Masayuki, Hiki-gun, Saitama 355-0215 (JP)
(74) Representative: Hoffmann Eitle
(86) International application number: PCT/JP2019/012863
(87) International publication number: WO 2019/189186

(57) **Abstract**

[Problem to be Solved]

Provided is a curable composition for inkjet printing for obtaining a cured product excellent in heat resistance, adhesion to a substrate, and hardness.

[Solution]

The curable composition for inkjet printing comprises (A) a multi-branched oligomer or polymer having an ethylenically unsaturated group, (B) a photopolymerization initiator, and (C) a thermosetting compound.

## Description

### Technical Field

The present invention relates to a curable composition for inkjet printing and, in particular, a curable composition for inkjet printing for obtaining a cured product excellent in heat resistance, hardness, and adhesion to a substrate, a cured product thereof, and an electronic component having the cured product.

### Background Art

An inkjet printing method used in the production of electronic components such as a printed wiring board is a technique that can directly form a desired cured pattern by printing a pattern directly onto a base material based on digital data using an inkjet printer, and by quickly curing the pattern utilizing an energy ray such as UV. Thus, this method enables effective production as compared with the conventional methods (a photographic developing method and a screen printing method). Another advantage is that the inkjet printing method is noncontact printing and thus it is easy to cope with the base material having unevenness or the base material having flexibility so that application to electronic components such as a printed wiring board is expected.

Among printed wiring board materials, solder resists formed as a protective film of the outermost layer, which have been subjected to pattern formation by alkali development, have advantages in that the exposure and development process are unnecessary, management of a production line is easily performed, and it is environmentally friendly, by applying the inkjet printing method.

In recent years, various developments have been made to obtain a resin composition that satisfies both the demand for a low viscosity in order to apply an inkjet method and the demand for obtaining physical properties originally required as the resist ink such as heat resistance, chemical resistance, adhesion, and hardness. Accordingly, for example, the curable compositions of Patent Literatures 2 and 3 have been suggested. These curable compositions are considered to have a viscosity suitable for inkjet and desired characteristics required as a resist film by using a curable compound having a low molecular weight and a relatively low amount of filler.

### Prior Art Literature

### Patent Literature

Patent Literature 1 International Publication No. WO 2013/146706
Patent Literature 2 Japanese Patent No. 5758172
Patent Literature 3 Japanese Patent No. 5758472

### [Summary of Invention]

### [Problems to be solved by the Invention]

There is a restriction that the ink (curable composition) used for the inkjet printing method needs to have a lower viscosity as compared with that of the ink in the above conventional methods. In order to lower the viscosity of ink, a large amount of diluents having a low viscosity are used so that various characteristics such as heat resistance tend to be lowered. However, when the ink is used as a solder resist of a printed wiring board, heat resistance is very important. In particular, the occurrence of cracks after reflow may reduce the reliability of the component. There has been no curable composition that has excellent heat resistance as an inkjet ink, has no occurrence of cracks after reflow, and can be suitably used as a curable composition for a printed wiring board. In addition, an increase of the adhesion to a substrate (see Patent Literature 1) and hardness of a cured product of the curable composition is still continuously demanded.

Therefore, the first object of the present invention is to provide a curable composition for inkjet printing for obtaining a cured product excellent in heat resistance, in particular, resistance to cracking during reflow, resistance to Ni/Pd/Au plating, adhesion to a substrate, and hardness.

Another first object of the present invention is to provide a cured product obtained by curing the curable composition for inkjet printing, and an electronic component having the cured product.

Here, the curable resin composition of Patent Literature 2 sets the amount of filler low to ensure adhesion to a substrate, and the resistance to cracking, hardness, and low warpage after curing the resist ink are not necessarily satisfactory.

Moreover, the composition described in Patent Literature 3 contains a relatively large amount of filler, so that the composition has an elevated hardness, but has difficulty in obtaining adhesion.

That is, the adhesion and the hardness tend to contradict each other in the conventional curable compositions, and the composition that simultaneously increases them and has a viscosity applicable to an inkjet method is not yet obtained.

Furthermore, while the heat resistance of the resist to a base body is increased to a certain level in the curable resin compositions of Patent Literatures 2 and 3, the resistance, for example, when performing a treatment under severe conditions such as nickel-gold plating, is still insufficient and a further increase thereof is desired.

Accordingly, the second object of the present invention is to provide a curable composition having no disadvantage of the prior art, a viscosity appropriate for application to an inkjet printer, and excellent adhesion, resistance to cracking, hardness, and low warpage after curing in combination.

### Means for Solving the Problems

The above first object can be achieved by a curable composition for inkjet printing, comprising:
(A) a multi-branched oligomer or polymer having an ethylenically unsaturated group,
(B) a photopolymerization initiator, and
(C) a thermosetting compound.

It has been found by the present inventors that a curable composition having a viscosity suitable for an inkjet printing method can be obtained by using a multi-branched oligomer or polymer having an ethylenically unsaturated group as a component to be contained in the curable composition used for inkjet printing and by further using a photopolymerization initiator and a thermosetting compound in combination; and a cured product excellent in heat resistance, in particular, resistance to cracking during reflow, resistance to Ni/Pd/Au plating, adhesion to a substrate, and hardness can be obtained.

The preferred aspect of the curable composition for inkjet printing of the present invention is as follows.
(1) The multi-branched oligomer or polymer has a hyperbranched or dendrimer structure.
(2) The viscosity at 50°C measured according to JIS Z 8803 is 50 mPa·s or less.
(3) To solve the second object of the present invention, the curable composition for inkjet printing further comprises (D) a filler having a Mohs hardness of 5 or more. In addition to the above characteristics, it can have excellent low warpage and hardness after curing.
(4) The number of (meth)acryloyl groups of (A) the multi-branched oligomer or the multi-branched polymer having an ethylenically unsaturated group exceeds 6.
(5) (C) The thermosetting compound is blocked isocyanate.

Moreover, the above object can be achieved by a cured product obtained by curing the curable composition for inkjet printing of the present invention and an electronic component having the cured product.

The present invention also provides a method of producing a printed wiring board comprising a step of drawing directly on a substrate with an inkjet printer and a step of curing the curable composition for inkjet printing drawn by irradiation with light to form a resist pattern.

### Effects of Invention

First, according to the present invention, a curable composition for inkjet printing for obtaining a cured product excellent in heat resistance, in particular, resistance to cracking during reflow, resistance to Ni/Pd/Au plating, adhesion to a substrate, and hardness can be provided.

Second, according to the present invention, the curable composition for inkjet printing further comprises (D) a filler having a Mohs hardness of 5 or more. The cured product thereof has excellent adhesion to a substrate and excellent in all of resistance to cracking, hardness, and low warpage, and it can also be used for not only the rigid substrate but also the flexible substrate.

### Brief Description of Drawing

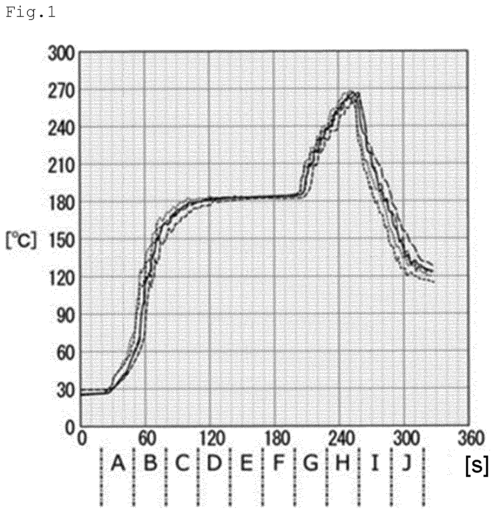

[Fig. 1] Fig. 1 is a graph showing the temperature measured in the evaluation of the resistance to cracking after reflow.

### Mode for carrying out the Invention

Hereinafter, the present invention will be described in detail. As described above, the curable composition for inkjet printing of the present invention comprises (A) a multi-branched oligomer or polymer having an ethylenically unsaturated group, (B) a photopolymerization initiator, and (C) a thermosetting compound.

### <(A) Multi-branched oligomer or polymer having ethylenically unsaturated group>

In the present invention, the multi-branched oligomer or polymer having an ethylenically unsaturated group is a compound having at least one ethylenically unsaturated group in the multi-branched oligomer or polymer (which refer to the oligomer or the polymer having a plurality of branched chains in one molecule) skeleton. The ethylenically unsaturated group derives from functional groups such as a (meth)acryloyl group and the multi-branched oligomer or polymer may have a plurality of ethylenically unsaturated groups in one molecule. The (meth)acryloyl group is a concept encompassing both an acryloyl group and a methacryloyl group.

The number of ethylenically unsaturated groups in one molecule is preferably 3 or more, more preferably 4 to 30, and further preferably exceeds 6, and it is selected in a range not impairing the desired effect of the composition of the present invention. Since the photocurable composition of the present invention is used for inkjet application, one having a viscosity of 150 mPa·s or less at room temperature (25°C) and 30 or less functional groups is particularly preferably used. The number of ethylenically unsaturated groups refers to the number of ethylenically unsaturated groups in one molecule of the multi-branched oligomer or polymer.

Preferred examples of the multi-branched oligomer and/or polymer having an ethylenically unsaturated group (hereinafter also referred to simply as the "multi-branched oligomer or polymer") include a compound having a dendrimer structure (dendritic structure) (hereinafter also referred to simply as the dendrimer), a compound having a hyperbranched structure (hereinafter also referred to simply as the hyperbranched (oligomer or polymer)), a compound having a star structure (oligomer or polymer), and a compound having a graft structure (oligomer or polymer), which are compounds having a functional group having an ethylenically unsaturated bond such as a (meth)acryloyl group. Among these, the dendritic oligomer or polymer is preferred in that the composition is excellent in heat resistance, in particular, resistance to cracking during reflow, resistance to Ni/Pd/Au plating, hardness, and adhesion to a substrate. Since (A) the multi-branched oligomer or polymer having an ethylenically unsaturated group has a relatively low viscosity even by increasing the number of functional groups or the amount to be used, it is significant for making the curable composition to have high hardness.

In the present invention, the dendrimer widely refers to compounds having a structure in which branched chains are radially extended. The specific type of the dendrimer is not particularly limited, and one or more can be selected from known dendrimers such as amidoamine-based dendrimers, phenyl ether-based dendrimers, and hyperbranched polyethylene glycol.

The production method of the dendrimer is also not particularly limited, and known production methods such as a divergent method in which molecules are bonded to the central core molecule in order of generation to form the branches, a convergent method in which branch portions synthesized in advance are bonded to the core molecule, and a method for synthesizing in a single step using a monomer ABx that comprises a branch portion having two or more reaction points B and a linking portion having another reaction point A in one molecule, can be employed.

As the multi-branched oligomer or polymer, commercially available products can also be used and examples thereof include Etercure 6361-100 (manufactured by Eternal Materials Co., Ltd.), Doublermer (DM) 2015 (manufactured by DOUBLE BOND CHEMICAL IND. CO., LTD.), SP1106 (manufactured by Miwon Specialty Chemical Co., Ltd.), and Viscoat #1000 (manufactured by OSAKA ORGANIC CHEMICAL INDUSTRY LTD.).

Additionally, the multi-branched oligomer or polymer is available from Iris Biotech GmbH, KANTO CHEMICAL CO., INC., Merck Millipore, QIAGEN, Sigma-Aldrich, Techno Chemical Corporation, DOUBLE BOND CHEMICAL IND. CO., LTD., OSAKA ORGANIC CHEMICAL IND. LTD., Hakuto Co., Ltd., and the like. The multi-branched oligomer or polymer can be used singly or in combinations of two or more.

The viscosity of the multi-branched oligomer or polymer at 25°C is, for example, preferably 1000 mPa·s or less, and particularly preferably 800 mPa·s or less. Within this range, the inkjet printability of the curable composition for inkjet printing of the present invention is good. Viscosity refers to the viscosity measured according to JIS Z 8803.

The multi-branched oligomer or polymer has a weight average molecular weight (Mw) of generally 1000 to 20000, and preferably 1000 to 8000. The weight average molecular weight (Mw) is the molecular weight in terms of polystyrene, based on the molecular weight distribution curve by a gel permeation chromatography.

The content of the multi-branched oligomer or polymer having an ethylenically unsaturated group is 0.1 to 80% by mass, and preferably 1.5 to 60% by mass based on the mass of the curable composition for inkjet printing of the present invention.

### <(B) Photopolymerization initiator>

The photopolymerization initiator is not particularly limited as long as it can polymerize (meth)acrylate by irradiation with energy ray, and a radical polymerization initiator can be used. "(Meth)acrylate" as used herein and in the claims is a collective term referring to acrylate, methacrylate, and a mixture thereof, and the same applies to other similar expressions.

As a radical photopolymerization initiator, all compounds that generate a radical by light, laser, electron beam, and the like and initiate radical polymerization reaction can be used. Examples of the radical photopolymerization initiator include benzoins and benzoin alkyl ethers such as benzoin, benzoin methyl ether, benzoin ethyl ether, and benzoin isopropyl ether; acetophenones such as acetophenone, 2,2-dimethoxy-2-phenylacetophenone, 2,2-diethoxy-2-phenylacetophenone, and 1,1-dichloroacetophenone; aminoacetophenones such as 2-methyl-1-[4-(methylthio)phenyl]-2-morpholinopropane-1-one, 2-benzyl-2-dimethylamino-1-(4-morpholinophenyl)-butane-1-one, and N,N-dimethylaminoacetophenone; anthraquinones such as 2-methylanthraquinone, 2-ethylanthraquinone, 2-t-butylanthraquinone, and 1-chloroanthraquinone; thioxanthones such as 2,4-dimethylthioxanthone, 2,4-diethylthioxanthone, 2-chlorothioxanthone, and 2,4-diisopropylthioxanthone; ketals such as acetophenone dimethyl ketal and benzyl dimethyl ketal; 2,4,5-triarylimidazole dimers; riboflavin tetrabutyrate; thiol compounds such as 2-mercaptobenzimidazole, 2-mercaptobenzoxazole, and 2-mercaptobenzothiazole; organohalogen compounds such as 2,2,2-tribromoethanol, and tribromomethyl phenyl sulfone; benzophenones such as benzophenone and 4,4'-bisdiethylaminobenzophenone, or xanthones; and acylphosphine oxides such as 2,4,6-trimethylbenzoyldiphenylphosphine oxide and bis(2,4,6-trimethylbenzoyl)-phenylphosphine oxide.

One of or a mixture of a plurality of the radical photopolymerization initiators described above can be used. In addition to these, photoinitiator aids such as tertiary amines such as N,N-dimethylaminobenzoic acid ethyl ester, N,N-dimethylaminobenzoic acid isoamyl ester, pentyl-4-dimethylaminobenzoate, triethylamine, and triethanolamine can further be used. In addition, titanocene compounds such as Omnirad 784 (manufactured by IGM Resins) having absorption in the visible light region can also be added to a radical photopolymerization initiator to promote a photoreaction. The components to be added to the radical photopolymerization initiator are not limited thereto, and the components that absorb light in the ultraviolet region or in the visible light region and cause radical polymerization of unsaturated groups such as (meth)acryloyl groups can be used singly or in combinations of a plurality of them, irrespective of a photopolymerization initiator and a photoinitiator aid.

Examples of product names of commercially available photopolymerization initiators include Omnirad 907, Omnirad 127, Omnirad 379, Omnirad 819, Omnirad BDK, and Omnirad TPO (all manufactured by IGM Resins).

The amount of the photopolymerization initiator blended is, for example, 0.1 to 50% by mass, particularly 0.1 to 20% by mass, preferably 0.5 to 15% by mass, more preferably 0.5 to 10% by mass, and further preferably 1 to 10% by mass based on the mass of the curable composition for inkjet printing of the present invention.

### <(C) Thermosetting compound>

The curable composition for inkjet printing of the present invention comprises a thermosetting compound. Examples of the thermosetting compound include known thermosetting resins such as amino resins such as melamine, isocyanate, melamine resins, benzoguanamine resins, melamine derivatives, and benzoguanamine derivatives, block isocyanate compounds, cyclocarbonate compounds, thermosetting compounds having a cyclic (thio)ether group, bismaleimide, and carbodiimide resins. Among them, having excellent heat resistance, melamine or a block isocyanate compound is preferably used. These thermosetting compounds may be used singly or in combinations of two or more.

The thermosetting compound having a plurality of cyclic (thio)ether groups within the molecule is a compound having a plurality of any one or two of three-, four-, or five-membered cyclic (thio)ether groups within the molecule, and examples include a compound having a plurality of epoxy groups within the molecule, i.e., a polyfunctional epoxy compound, a compound having a plurality of oxetanyl groups within the molecule, i.e., a polyfunctional oxetane compound, and a compound having a plurality of thioether groups within the molecule, i.e., an episulfide resin.

Examples of the polyfunctional epoxy compound include, but are not limited to, epoxidized vegetable oils such as Adeka Cizer O-130P and Adeka Cizer O-180A manufactured by ADEKA Corporation; bisphenol A epoxy resins such as jER 828 manufactured by Mitsubishi Chemical Corporation, EHPE3150 manufactured by Daicel Chemical Industries, Ltd., Epicron 840 manufactured by DIC Corporation, Epotohto YD-011 manufactured by Tohto Kasei Co.,Ltd., D.E.R. 317 manufactured by Dow Chemical Company, Sumi-Epoxy ESA-011 manufactured by Sumitomo Chemical Industry Company Limited, and A.E.R. 330 manufactured by Asahi Kasei Corporation (all trade names); hydroquinone epoxy resins, bisphenol F epoxy resins such as YSLV-80XY manufactured by NIPPON STEEL Chemical & Material CO., LTD., and thioether epoxy resins such as YSLV-120TE manufactured by NIPPON STEEL Chemical & Material CO., LTD.; brominated epoxy resins such as jER YL 903 manufactured by Mitsubishi Chemical Corporation, Epiclon 152 manufactured by DIC Corporation, Epotohto YDB-400 manufactured by Tohto Kasei Co.,Ltd., D.E.R. 542 manufactured by Dow Chemical Company, Sumi-Epoxy ESB-400 manufactured by Sumitomo Chemical Industry Company Limited, and A.E.R. 711 manufactured by Asahi Kasei Corporation (all trade names); novolac epoxy resins such as jER 152 manufactured by Mitsubishi Chemical Corporation, D.E.N. 431 manufactured by Dow Chemical Company, Epiclon N-730 manufactured by DIC Corporation, Epotohto YDCN-701 manufactured by Tohto Kasei Co., Ltd., EPPN-201 manufactured by Nippon Kayaku Co., Ltd., Sumi-Epoxy ESCN-195X manufactured by Sumitomo Chemical Industry Company Limited, and A.E.R. ECN-235 manufactured by Asahi Kasei Corporation (all trade names); biphenol novolac epoxy resins such as NC-3000 manufactured by Nippon Kayaku Co., Ltd.; bisphenol F epoxy resins such as Epiclon 830 manufactured by DIC Corporation, jER 807 manufactured by Mitsubishi Chemical Corporation, and Epotohto YDF-170, YDF-175, and YDF-2004 manufactured by Tohto Kasei Co., Ltd. (all trade names); hydrogenated bisphenol A epoxy resins such as Epotohto ST-2004 (trade name) manufactured by Tohto Kasei Co., Ltd.; glycidylamine epoxy resins such as jER 604 manufactured by Mitsubishi Chemical Corporation, Epotohto YH-434 manufactured by Tohto Kasei Co., Ltd., and Sumi-Epoxy ELM-120 manufactured by Sumitomo Chemical Industry Company Limited. (all trade names); hydantoin epoxy resins; alicyclic epoxy resins such as Celloxide 2021 manufactured by Daicel Chemical Industries, Ltd. (trade name); trihydroxyphenyl methane epoxy resins such as EPPN-501 manufactured by Nippon Kayaku Co., Ltd. (trade name); bixylenol or biphenol epoxy resins such as YL-6056, YX-4000, YL-6121 manufactured by Mitsubishi Chemical Corporation (all trade names) or mixtures thereof; bisphenol S epoxy resins such as EBPS-200 manufactured by Nippon Kayaku Co., Ltd., EPX-30 manufactured by ADEKA Corporation, and EXA-1514 manufactured by DIC Corporation (trade names); bisphenol A novolac epoxy resins such as jER 157S (trade name) manufactured by Mitsubishi Chemical Corporation; tetraphenylol ethane epoxy resins such as jER YL-931 manufactured by Mitsubishi Chemical Corporation (trade name); heterocyclic epoxy resins such as TEPIC manufactured by Nissan Chemical Industries, Ltd. (trade name); diglycidyl phthalate resins such as BLEMMER DGT manufactured by NOF CORPORATION; tetraglycidylxylenoylethane resins such as ZX-1063 manufactured by Tohto Kasei Co., Ltd.; naphthalene group-containing epoxy resins such as ESN-190 manufactured by NIPPON STEEL Chemical and HP-4032 manufactured by DIC Corporation; epoxy resins having a dicyclopentadiene skeleton such as HP-7200 manufactured by DIC Corporation; glycidyl methacrylate copolymer-based epoxy resins such as CP-50S and CP-50M manufactured by NOF CORPORATION; moreover, copolymer epoxy resins of cyclohexyl maleimide and glycidyl methacrylate; and epoxy-modified polybutadiene rubber derivatives (such as PB-3600 manufactured by Daicel Chemical Industries, Ltd.) and CTBN-modified epoxy resins (such as YR-102 and YR-450 manufactured by Tohto Kasei Co., Ltd.). These epoxy resins can be used singly or in combinations of two or more. Among these, in particular, novolac epoxy resins, bixylenol epoxy resins, biphenol epoxy resins, biphenol novolac epoxy resins, naphthalene epoxy resins, or mixtures thereof are preferable.

Examples of the polyfunctional oxetane compound include polyfunctional oxetanes such as bis[(3-methyl-3-oxetanylmethoxy)methyl] ether, bis[(3-ethyl-3-oxetanylmethoxy)methyl] ether, 1,4-bis[(3-methyl-3-oxetanylmethoxy)methyl]benzene, 1,4-bis[(3-ethyl-3-oxetanylmethoxy)methyl]benzene, (3-methyl-3-oxetanyl)methyl acrylate, (3-ethyl-3-oxetanyl)methyl acrylate, (3-methyl-3-oxetanyl)methyl methacrylate, (3-ethyl-3-oxetanyl)methyl methacrylate, oligomers or copolymers thereof, and etherified products between oxetane alcohol and a resin having a hydroxyl group such as a novolac resin, poly(p-hydroxystyrene), cardo bisphenol, calixarene, calixresorcinarene, or silsesquioxane. Another example is a copolymer of an unsaturated monomer having an oxetane ring and alkyl (meth)acrylate.

A monomer having both a radically polymerizable moiety (a methacryl group) and a cationically polymerizable moiety (an oxetanyl moiety) within the molecule, such as (3-methyl-3-oxetanyl)methyl acrylate, (3-ethyl-3-oxetanyl)methyl acrylate, (3-methyl-3-oxetanyl)methyl methacrylate, or (3-ethyl-3-oxetanyl)methyl methacrylate, is a photocurable component as well as a thermosetting compound, and is therefore preferably contained in the composition when performing two-step curing of photocuring and heat curing.

Examples of such components other than polyfunctional oxetane compounds include ethoxylated bisphenol A diacrylate (product name, A-BPE-4, manufactured by SHIN-NAKAMURA CHEMICAL Co., Ltd.), 4-hydroxybutyl acrylate glycidyl ether (product name, 4HBAGE, manufactured by Nihon Kasei Co., Ltd.), and 3,4-epoxycyclohexyl methylmethacrylate (product name, Cyclomer M100, manufactured by Daicel Corporation).

An example of the compound having a plurality of cyclic thioether groups within the molecule is bisphenol A episulfide resin YL7000 manufactured by Mitsubishi Chemical Corporation. An episulfide resin, in which the oxygen atom of the epoxy group of a novolac epoxy resin is replaced with a sulfur atom by using the same synthesis method, or the like is also usable.

Examples of amino resins such as melamine derivatives and benzoguanamine derivatives include methylol melamine compounds, methylol benzoguanamine compounds, methylol glycoluril compounds, and methylolurea compounds. Moreover, alkoxymethylated melamine compounds, alkoxymethylated benzoguanamine compounds, alkoxymethylated glycoluril compounds, and alkoxymethylated urea compounds can be obtained by converting the methylol groups of methylol melamine compounds, methylol benzoguanamine compounds, methylol glycoluril compounds, and methylolurea compounds, respectively, into alkoxymethyl groups. The kind of this alkoxymethyl group is not particularly limited, and may be, for example, a methoxymethyl group, an ethoxymethyl group, a propoxymethyl group, a butoxymethyl group, or the like. In particular, a melamine derivative having a formalin concentration of 0.2% or less, which is physically and environmentally friendly, is preferable.

Examples of commercially available products thereof include Cymel 300, Cymel 301, Cymel 303, Cymel 370, Cymel 325, Cymel 327, Cymel 701, and Cymel 266 (all manufactured by Mitsui Cyanamid Ltd.), and Nikalac Mx-750, Nikalac Mx-032, Nikalac Mx-270, Nikalac Mx-280, Nikalac Mx-290, and Nikalac Mx-706 (all manufactured by SANWA Chemical Co., Ltd.). Such thermosetting compounds may be used singly or in combinations of two or more.

The isocyanate compound and the block isocyanate compound are compounds having a plurality of isocyanate groups or block isocyanate groups within one molecule. Examples of such compounds having a plurality of isocyanate groups or block isocyanate groups within one molecule include polyisocyanate compounds and block isocyanate compounds. The block isocyanate group is a group obtained by reacting an isocyanate group with a blocking agent to protect and temporarily inactivate it, and when the block isocyanate group is heated to a specific temperature, the blocking agent dissociates, and an isocyanate group is produced. By adding the polyisocyanate compound or the block isocyanate compound, the curability and the toughness of an obtained cured product can be increased.

As such a polyisocyanate compound, for example, aromatic polyisocyanate, aliphatic polyisocyanate, or alicyclic polyisocyanate is used.

Specific examples of the aromatic polyisocyanate include 4,4'-diphenylmethane diisocyanate, 2,4-tolylene diisocyanate, 2,6-tolylene diisocyanate, naphthalene-1,5-diisocyanate, o-xylylene diisocyanate, m-xylylene diisocyanate, and 2,4-tolylene dimer.

Specific examples of the aliphatic polyisocyanate include tetramethylene diisocyanate, hexamethylene diisocyanate, methylene diisocyanate, trimethylhexamethylene diisocyanate, 4,4-methylenebis(cyclohexyl isocyanate), and isophorone diisocyanate.

Specific examples of the alicyclic polyisocyanate include bicycloheptane triisocyanate. In addition, examples include adducts, burettes, and isocyanurates of the isocyanate compounds listed above.

As a block isocyanate compound, a product of an addition reaction between an isocyanate compound and an isocyanate blocking agent is used. Examples of the isocyanate compound capable of reacting with the blocking agent include the polyisocyanate compounds described above.

Examples of the isocyanate blocking agent include phenol-based blocking agents such as phenol, cresol, xylenol, chlorophenol, and ethylphenol; lactam-based blocking agents such as ε-caprolactam, δ-valerolactam, γ-butyrolactam, and β-propiolactam; active methylene-based blocking agents such as ethyl acetoacetate and acetylacetone; alcohol-based blocking agents such as methanol, ethanol, propanol, butanol, amyl alcohol, ethylene glycol monomethyl ether, ethylene glycol monoethyl ether, ethylene glycol monobutyl ether, diethylene glycol monomethyl ether, propylene glycol monomethyl ether, benzyl ether, methyl glycolate, butyl glycolate, diacetone alcohol, methyl lactate, and ethyl lactate; oxime-based blocking agents such as formaldehyde oxime, acetaldoxime, acetoxime, methyl ethyl ketoxime, diacetyl monooxime, and cyclohexane oxime; mercaptan-based blocking agents such as butyl mercaptan, hexyl mercaptan, t-butyl mercaptan, thiophenol, methylthiophenol, and ethylthiophenol; acid amide-based blocking agents such as acetic acid amide and benzamide; imide-based blocking agents such as succinimide and maleic imide; amine-based blocking agents such as xylidine, aniline, butylamine, and dibutylamine; imidazole-based blocking agents such as imidazole and 2-ethylimidazole; imine-based blocking agents such as methyleneimine and propyleneimine.

The block isocyanate compound may be a commercially available product, and examples include Sumidur BL-3175, BL-4165, BL-1100, and BL-1265, Desmodur TPLS-2957, TPLS-2062, TPLS-2078, and TPLS-2117, and Desmotherm 2170 and Desmotherm 2265 (all manufactured by Sumitomo Bayer Urethane Co., Ltd.), Coronate 2512, Coronate 2513, and Coronate 2520 (all manufactured by Nippon Polyurethane Industry Co., Ltd.), B-830, B-815, B-846, B-870, B-874, and B-882 (all manufactured by Mitsui Takeda Chemicals Inc.), TPA-B80E, 17B-60PX, and E402-B80T (all manufactured by Asahi Kasei Chemicals Corporation). Sumidur BL-3175 and BL-4265 are obtained by using methyl ethyl oxime as a blocking agent. Such compounds having a plurality of isocyanate groups or block isocyanate groups within one molecule may be used singly or in combinations of two or more.

The amount of (C) the thermosetting compound blended is preferably 1 to 30% by mass, and particularly preferably 3 to 25% based on the mass of the curable composition for inkjet printing of the present invention. When the amount blended is 1% by mass or more, the toughness and the heat resistance of a coating film are further increased. On the other hand, when it is 30% by mass or less, both characteristics such as heat resistance and the ejection property are excellent.

### <(D) Filler having Mohs hardness of 5 or more>

The present invention may further comprise a filler having a Mohs (Friedrich Mohs) hardness of 5 or more. This not only further increases the adhesion and the hardness of the cured coating film of the curable composition, but also enables to obtain excellent effects on the characteristics such as resistance to cracking and low warpage. In general, although these characteristics are increased by using a filler having high hardness, it is difficult to give further adhesion to a cured product. However, blending the filler having a Mohs hardness of 5 or more allows to further increase the resistance to cracking while maintaining adhesion and to obtain a cured product excellent in hardness and low warpage.

The upper limit of the Mohs hardness of the filler used in the present invention is preferably 9. By using a material having a Mohs hardness of 9 or less, the moldability of the curable composition is particularly good.

Examples of (D) the filler having a Mohs hardness of 5 or more include iron oxides (Mohs hardness: 5 to 6), titanium oxides (Mohs hardness: 5.5 to 7.5), magnesium oxides (Mohs hardness: 5.5 to 6), calcium silicates (Mohs hardness: 5.9), calcium carbonates (Mohs hardness: 5), glasses (powder) (Mohs hardness: 5), silica (Mohs hardness: 7), zirconium oxide (Mohs hardness: 7), and zinc oxides (Mohs hardness: 5.5 to 5.7).

Besides these, in addition to (D) the filler having a Mohs hardness of 5 or more described above, other fillers can be used in the present invention. Examples of the filler that can be used in combination in the present invention include barium titanates, barium sulfates, mica, talc, aluminum silicates, bentonites, aluminum hydroxides, magnesium hydroxides, Neuburg siliceous earths, hydrotalcites, clays, potassium titanates, antimony oxides, white leads, and zinc sulfides.

Among them, titanium oxides are particularly preferably used in the present invention. The titanium oxide may be titanium oxides having any structure of rutile type, anatase type, and ramsdellite type, and these may be used singly or in combinations of two or more. Among them, the ramsdellite type titanium oxide can be obtained by subjecting ramsdellite type Li0.5TiO₂ to lithium elimination treatment by chemical oxidation.

The amount of (D) the filler having a Mohs hardness of 5 or more blended is preferably 10 to 70% by mass, particularly preferably in the range of 15 to 55% by mass, and more preferably in the range of 20 to 50% by mass of the total mass of the curable composition based on the solid matter in the curable resin composition.

By blending within the above range, low warpage can be obtained.

In the present invention, the titanium oxide may be a rutile type titanium oxide or an anatase type titanium oxide and a rutile type titanium is preferably used. The anatase type titanium oxide, which is also a titanium oxide, has a high brightness compared to that of the rutile type titanium oxide and thus commonly used as a white pigment. However, the anatase type titanium oxide has the photocatalytic activity so that the light irradiated from, in particular, LED may cause the discoloration of the resin in an insulating resin composition. On the contrary, the rutile type titanium oxide has almost no photoactivity although the brightness is slightly inferior to that of the anatase type, and thus, the deterioration (yellowing) of the resin by light due to the photoactivity of the titanium oxide is significantly suppressed and the rutile type titanium oxide is also stable to heat. For these reasons, when a rutile type titanium oxide is used as a white pigment in an insulating layer of an electronic component such as a printed wiring board on which LEDs are mounted, discoloration can be suppressed for a long period of time. The titanium oxide is a titanium dioxide generally represented by TiO₂, and it may be represented by TiOₓ, and x may be less than 2 and 1.5 or more.

The average particle size of primary particles of the white pigment (number average size (MN)) is preferably 1 µm or less, and particularly preferably 0.01 µm to 1 µm or less. By setting to 1 µm or less, the dispersibility of the pigment increases, and the ejection property in the case of using the curable composition in an inkjet method increases. In addition, having a particle size of 0.01 µm or more, aggregation hardly occurs. As used herein, the average particle size is the average particle size (D50) including not only the particle size of primary particles, but also the particle size of secondary particles (aggregates), and is the value of D50 measured by a laser diffraction method. Examples of a measuring apparatus by the laser diffraction method include Microtrac series manufactured by NIKKISO CO., LTD.

As the rutile type titanium oxide, known ones can be used. As a method for producing the rutile type titanium oxide, there are two kinds of methods including a sulfuric acid method and a chlorine method. In the present invention, any rutile type titanium oxides produced by any of the methods can be suitably used. Here, the sulfuric acid method refers to a process in which ilmenite ore or titanium slag is used as a raw material, which is dissolved in concentrated sulfuric acid to separate iron as iron sulfate, and the solution is hydrolyzed to obtain a precipitate of hydroxides, and then this precipitate is calcined at a high temperature to take out rutile type titanium oxide. On the other hand, the chlorine method refers to a process in which synthetic rutile or natural rutile is used as a raw material, which is allowed to react with chlorine gas and carbon at a high temperature of about 1000°C to synthesize titanium tetrachloride, and this is oxidized to take out rutile type titanium oxide. Among them, the rutile type titanium oxide produced by the chlorine method has a significant effect of suppressing the deterioration (yellowing) of the resin by heat in particular and is preferably used in the present invention, particularly when a white curable composition is to be obtained.

Examples of the commercially available rutile type titanium oxide include TIPAQUE R-820, TIPAQUE R-830, TIPAQUE R-930, TIPAQUE R-550, TIPAQUE R-630, TIPAQUE R-680, TIPAQUE R-670, TIPAQUE R-680, TIPAQUE R-670, TIPAQUE R-780, TIPAQUE R-850, TIPAQUE CR-50, TIPAQUE CR-57, TIPAQUE CR-80, TIPAQUE CR-90, TIPAQUE CR-93, TIPAQUE CR-95, TIPAQUE CR-97, TIPAQUE CR-60, TIPAQUE CR-63, TIPAQUE CR-67, TIPAQUE CR-58, TIPAQUE CR-85, and TIPAQUE UT771 (all manufactured by ISHIHARA SANGYO KAISHA, LTD.); TIPURE R-100, TIPURE R-101, TIPURE R-102, TIPURE R-103, TIPURE R-104, TIPURE R-105, TIPURE R-108, TIPURE R-900, TIPURE R-902, TIPURE R-960, TIPURE R-706, and TIPURE R-931 (all manufactured by DuPont); R-25, R-21, R-32, R-7E, R-5N, R-61N, R-62N, R-42, R-45M, R-44, R-49S, GTR-100, GTR-300, D-918, TCR-29, TCR-52, and FTR-700 (all manufactured by SAKAI CHEMICAL INDUSTRY CO., LTD.).

Among the above, TIPAQUE CR-50, TIPAQUE CR-57, TIPAQUE CR-80, TIPAQUE CR-90, TIPAQUE CR-93, TIPAQUE CR-95, TIPAQUE CR-97, TIPAQUE CR-60, TIPAQUE CR-63, TIPAQUE CR-67, TIPAQUE CR-58, TIPAQUE CR-85, and TIPAQUE UT771 (manufactured by ISHIHARA SANGYO KAISHA, LTD.); TIPURE R-100, TIPURE R-101, TIPURE R-102, TIPURE R-103, TIPURE R-104, TIPURE R-105, TIPURE R-108, TIPURE R-900, TIPURE R-902, TIPURE R-960, TIPURE R-706, and TIPURE R-931 (manufactured by DuPont), all of which are produced by the chlorine method, are preferably used.

In addition, as the anatase type titanium oxide, known ones can be used. Examples of the commercially available anatase type titanium oxide include TITON A-110, TITON TCA-123E, TITON A-190, TITON A-197, TITON SA-1, and TITON SA-1L (manufactured by SAKAI CHEMICAL INDUSTRY CO., LTD.); TA-100, TA-200, TA-300, TA-400, TA-500, and TP-2 (manufactured by Fuji Titanium Industry Co., Ltd.); TITANIX JA-1, TITANIX JA-3, TITANIX JA-4, TITANIX JA-5, and TITANIX JA-C (manufactured by TAYCA CORPORATION); KA-10, KA-15, KA-20, and KA-30 (manufactured by Titan Kogyo, Ltd.); TIPAQUE A-100, TIPAQUE A-220, and TIPAQUE W-10 (manufactured by ISHIHARA SANGYO KAISHA, LTD.).

### <(Meth)acrylate compound>

The curable composition for inkjet printing of the present invention may further comprise monofunctional, bifunctional, or higher (meth)acrylate compounds other than the (meth)acrylate compounds described above, or (meth)acrylate compounds ((meth)acrylate monomers) containing other functional groups (such as hydroxyl groups), or the like.

Examples of the monofunctional (meth)acrylate include aliphatic (meth)acrylates such as methyl (meth)acrylate, ethyl (meth)acrylate, butyl (meth)acrylate, hydroxyethyl (meth)acrylate, 4-hydroxybutyl (meth)acrylate, hydroxypropyl (meth)acrylate, butoxymethyl (meth)acrylate, 2-ethylhexyl (meth)acrylate, lauryl (meth)acrylate, isodecyl (meth)acrylate, and glycerol mono(meth)acrylate; alicyclic (meth)acrylates such as cyclohexyl (meth)acrylate, 4-(meth)acryloxytricyclo[5.2.1.02,6]decane, and isobornyl (meth)acrylate; aromatic (meth)acrylates such as phenoxyethyl (meth)acrylate, benzyl (meth)acrylate, phenyl (meth)acrylate, and 2-hydroxy-3-phenoxypropyl (meth)acrylate; modified (meth)acrylates such as aliphatic epoxy-modified (meth)acrylate; tetrahydrofurfuryl (meth)acrylate, 2-(meth)acryloxyalkyl phosphate, 2-(meth)acryloyloxyethyl phosphoric acid ester, (meth)acryloyloxyethyl phthalic acid, and γ-(meth)acryloxyalkyltrialkoxysilane.

Specific examples of the bifunctional (meth)acrylate include diol diacrylates such as 1,4-butanediol diacrylate, 1,6-hexanediol diacrylate, 1,9-nonanediol diacrylate, and 1,10-decanediol diacrylate; glycol diacrylates such as ethylene glycol diacrylate, diethylene glycol diacrylate, triethylene glycol diacrylate, tetraethylene glycol diacrylate, polyethylene glycol diacrylate, dipropylene glycol diacrylate, tripropylene glycol diacrylate, polypropylene glycol diacrylate, neopentyl glycol diacrylate, diacrylates of diols obtained by adding at least any one of ethylene oxide and propylene oxide to neopentyl glycol, and caprolactone-modified neopentyl glycol hydroxypivalate diacrylate; and diacrylates having a cyclic structure such as bisphenol AEO adduct diacrylate, bisphenol A PO adduct diacrylate, tricyclodecane dimethanol diacrylate, hydrogenated dicyclopentadienyl diacrylate, and cyclohexyl diacrylate.

Examples of commercially available products include Light Acrylate 1,6HX-A, 1,9ND-A, 3EG-A, and 4EG-A (names of products manufactured by Kyoeisha Chemical Co., Ltd.), HDDA, 1,9-NDA, DPGDA, and TPGDA (names of products manufactured by Daicel Cytec Co., Ltd.), Viscoat #195, #230, #230D, #260, #310HP, #335HP, and #700HV (names of products manufactured by Osaka Organic Chemical Industry Ltd.), and Aronix M-208, M-211B, M-220, M-225, M-240, and M-270 (names of products manufactured by TOAGOSEI CO., LTD.).

Examples of the hydroxyl group-containing (meth)acrylate include 2-hydroxy-3-acryloyloxypropyl(meth)acrylate, 2-hydroxy-3-phenoxyethyl (meth)acrylate, 1,4-cyclohexanedimethanol mono(meth)acrylate, 2-hydroxyethyl (meth)acrylate, 2-hydroxypropyl (meth)acrylate, 4-hydroxybutyl (meth)acrylate, pentaerythritol tri(meth)acrylate, dipentaerythritol monohydroxy penta(meth)acrylate, and 2-hydroxypropyl (meth)acrylate.

Examples of the commercially available products include Aronix M-5700 (name of product manufactured by TOAGOSEI CO., LTD.), 4HBA, 2HEA, and CHDMMA (all names of products manufactured by Nihon Kasei Co., Ltd.), BHEA, HPA, HEMA, and HPMA (all names of products manufactured by NIPPON SHOKUBAI CO., LTD.), and LIGHT ESTER HO, LIGHT ESTER HOP, and LIGHT ESTER HOA (all names of products manufactured by Kyoeisha Chemical Co., Ltd.). One of or a combination of a plurality of (meth)acrylate compounds having a hydroxy group (B) can be used.

Moreover, in the present invention, a bifunctional or higher (meth)acrylate monomer having a heterocyclic ring can be used.

The bifunctional or higher (meth)acrylate monomer having a heterocyclic ring is preferably one having a structure in any cyclic group of an alicyclic group or an aromatic group having one or two heteroatoms, in which a (meth)acryloyl group is directly bonded or bonded through an alkylene group (for example, a methylene group and an ethylene group) to each of two or more carbon atoms of the cyclic groups. The carbon to which no (meth)acryloyl group is bonded or the carbon to which (meth)acryloyl groups are bonded in the above cyclic group may further be substituted with a linear or branched lower alkyl group.

The one or two heteroatoms contained in a heterocyclic ring is any one of oxygen, nitrogen, and sulfur, or two of any combination thereof, preferably one or two oxygens, and particularly two oxygens.

Examples of the cyclic group having a heteroatom include divalent groups of alicyclic groups such as azolidine, oxolane, thiolane, piperidine, tetrahydropyran, tetrahydrothiopyran, hexamethylene imine, hexamethylene oxide, hexametheylene sulfide, dioxane, and dioxolane, and aromatic groups such as azole, oxole, thiol, pyridine, pyridinium, azepine, oxepin, thiepine, imidazole, pyrazole, oxazole, thiazole, imidazoline, morpholine, pyridazine, pyrimidine, and pyrazine.

Among them, the heterocyclic ring that constitutes a part of the bifunctional or higher (meth)acrylate monomer having a heterocyclic ring of the present invention is preferably a five- or six-membered alicyclic heterocyclic group such as tetrahydrofuran, tetrahydropyran, dioxane, and dioxolane.

Examples of the commercially available products of the bifunctional or higher (meth)acrylate monomer having a heterocyclic ring include KAYARAD R604 (manufactured by Nippon Kayaku Co., Ltd.).

Moreover, in the present invention, a (meth)acrylate monomer having a functional group containing an active hydrogen atom, such as OH groups, NH groups, NH2 groups, SH groups, and COOH groups can be used in combination. These components contribute to an increase of the curability of the coating film of the curable composition of the present invention by reacting with (C) the thermosetting compound.

For example, at least any one acrylate of ethylene oxide adducts or propylene oxide adducts of monofunctional alcohols such as pentaerythritol triacrylate and hydroxyl butyl acrylate, polyfunctional alcohols such as trimethylol propane and hydrogenated bisphenol A, or polyhydric phenols such as bisphenol A and biphenol; polyfunctional or monofunctional polyurethane acrylates which are isocyanate-modified products of hydroxyl group-containing acrylate; epoxy acrylates which are (meth)acrylic acid adducts of bisphenol A diglycidyl ether, hydrogenated bisphenol A diglycidyl ether, or phenol novolac epoxy resin, and corresponding methacrylate compounds can be used. Acrylic acids are also usable.

In the present invention, monofunctional and/or bifunctional (meth)acrylate monomers are preferably used and this enables pattern-printing of the photocurable and thermally curable composition of the present invention onto a base material such as a substrate with an optimal viscosity by an inkjet method, and thus a cured product obtained by curing this has extremely good heat resistance, hardness, and chemical resistance.

The content of the (meth)acrylate compound is preferably 20 to 90% by mass, and more preferably 30 to 80% by mass based on the mass of the curable composition for inkjet printing of the present invention.

### <Other components>

Additives such as antifoaming/leveling agents, thixotropy imparting agents/thickeners, coupling agents, dispersants, flame retardants, and fluorescent brightening agents can be contained in the curable composition for inkjet printing of the present invention as necessary.

As antifoaming agents/leveling agents, usable are compounds such as silicone, modified silicone, mineral oil, vegetable oil, fatty alcohol, fatty acid, metal soap, fatty acid amide, polyoxyalkylene glycol, polyoxyalkylene alkyl ether, and polyoxyalkylene fatty acid ester.

As thixotropy imparting agents/thickeners, usable are viscous minerals such as kaolinite, smectite, montmorillonite, bentonite, talc, mica, and zeolite, fine particle silica, silica gel, amorphous inorganic particles, polyamide-based additives, modified urea-based additives, and wax-based additives.

By adding an antifoaming /leveling agent and a thixotropy imparting agent/thickener, the surface properties of a cured product and the properties of a composition can be regulated.

As coupling agents, usable are those in which the alkoxy group is a methoxy group, an ethoxy group, acetyl, or the like, and the reactive functional group is vinyl, methacryl, acryl, epoxy, cyclic epoxy, mercapto, amino, diamino, acid anhydride, ureido, sulfide, isocyanate, or the like, for example, silane coupling agents such as vinyl-based silane compounds such as vinyl ethoxysilane, vinyl trimethoxysilane, vinyl·tris(β-methoxyethoxy) silane, and γ-methacryloxypropyltrimethoxysilane, amino-based silane compounds such as γ-aminopropyltrimethoxysilane, N-β-(aminoethyl)-γ-aminopropyltrimethoxysilane, N-β-(aminoethyl)-γ-aminopropylmethyldimethoxysilane, and γ-ureidopropyltriethoxysilane, epoxy-based silane compounds such as γ-glycidoxypropyltrimethoxysilane, β-(3,4-epoxycyclohexyl)ethyltrimethoxylane, and γ-glycidoxypropylmethyldiethoxysilane, mercapto-based silane compounds such as γ-mercaptopropyltrimethoxysilane, and phenylamino-based silane compounds such as N-phenyl-γ-aminopropyltrimethoxysilane; titanate-based coupling agents such as isopropyl triisostearoylated titanate, tetraoctyl bis(ditridecyl phosphite) titanate, bis(dioctyl pyrophosphate) oxyacetate titanate, isopropyl tridodecylbenzenesulfonyl titanate, isopropyl tris(dioctyl pyrophosphate) titanate, tetraisopropyl bis(dioctyl phosphite) titanate, tetra(1,1-diallyloxymethyl-1-butyl) bis(ditridecyl) phosphite titanate, bis(dioctyl pyrophosphate) ethylene titanate, isopropyl trioctanoyl titanate, isopropyl dimethacryl isostearoyl titanate, isopropyl tristearoyl diacrylic titanate, isopropyl tri(dioctyl phosphate) titanate, isopropyl tricumyl phenyl titanate, dicumylphenyloxyacetate titanate, and diisostearoyl ethylene titanate; zirconate-based coupling agents such as ethylenically unsaturated zirconate-containing compounds, neoalkoxy zirconate-containing compounds, neoalkoxy trisneodecanoyl zirconate, neoalkoxy tris(dodecyl)benzenesulfonyl zirconate, neoalkoxy tris(dioctyl)phosphate zirconate, neoalkoxy tris(dioctyl)pyrophosphate zirconate, neoalkoxy tris(ethylenediamino)ethyl zirconate, neoalkoxy tris(m-amino)phenyl zirconate, tetra(2,2-diallyloxymethyl)butyl, di(ditridecyl)phosphite zirconate, neopentyl(diallyl)oxy, trineodecanoyl zirconate, neopentyl(diallyl)oxy, tri(dodecyl)benzene-sulfonyl zirconate, neopentyl(diallyl)oxy, tri(dioctyl)phosphato zirconate, neopentyl(diallyl)oxy, tri(dioctyl)pyro-phosphato zirconate, neopentyl(diallyl)oxy, tri(N-ethylenediamino)ethyl zirconate, neopentyl(diallyl)oxy, tri(m-amino)phenyl zirconate, neopentyl(diallyl)oxy, trimethacryl zirconate(, neopentyl(diallyl)oxy, triacryl zirconate, dineopentyl(diallyl)oxy, diparaaminobenzoyl zirconate, dineopentyl(diallyl)oxy, di(3-mercapto)propionic zirconate, zirconium (IV) 2,2-bis(2-propenolatomethyl)butanolato, cyclodi[2,2-(bis2-propenolatomethyl)butanolato]pyrophosphato-O,O; and aluminate-based coupling agents such as diisobutyl(oleyl)acetoacetylaluminate and alkyl acetoacetate aluminum diisopropylate.

As dispersants, usable are high-molecular dispersants such as polycarboxylic acid-based, naphthalene sulfonic acid formalin condensation-based, polyethylene glycol, polycarboxylic acid partial alkyl ester-based, polyether-based, and polyalkylene polyamine-based dispersants, and low-molecular dispersants such as alkyl sulfonic acid-based, quaternary ammonium-based, higher alcohol alkylene oxide-based, polyhydric alcohol ester-based, and alkyl polyamine-based dispersants.

As flame retardants, usable are hydrated metal-based flame retardants such as aluminum hydroxide and magnesium hydroxide, red phosphorus, ammonium phosphate, ammonium carbonate, zinc borate, zinc stannate, molybdenum compound-based, bromine compound-based, chlorine compound-based, phosphoric acid ester, phosphorus-containing polyol, phosphorus-containing amine, melamine cyanurate, melamine compound, triazine compound, guanidine compound, silicone polymer flame retardants, and the like.

As fluorescent brightening agents, usable are benzoxazoyl derivatives, coumarin derivatives, styrene biphenyl derivatives, pyrazolone derivatives, and bis(triazinylamino)stilbene disulfonic acid derivatives.

In order to regulate the polymerization rate and the degree of polymerization, it is further possible to add a polymerization inhibitor and a polymerization retarder.

Moreover, a solvent for viscosity regulation may be used in the curable composition for inkjet printing of the present invention, but the amount of the solvent added is preferably as small as possible in order to prevent a decrease in drawing accuracy caused by volatilization of the solvent. It is more preferable not to contain a solvent for viscosity regulation.

A coloring pigment, dye, and the like may be added to the curable composition of the present invention for coloration. Usable coloring pigments, dyes, and the like are those known and commonly used that are indicated by color indices. Examples include Pigment Blue 15, 15:1, 15:2, 15:3, 15:4, 15:6, 16, 60, Solvent Blue 35, 63, 68, 70, 83, 87, 94, 97, 122, 136, 67, 70, Pigment Green 7, 36, 3, 5, 20, 28, Solvent Yellow 163, Pigment Yellow 24, 108, 193, 147, 199, 202, 110, 109, 139 179 185 93, 94, 95, 128, 155, 166, 180, 120, 151, 154, 156, 175, 181, 1, 2, 3, 4, 5, 6, 9, 10, 12, 61, 62, 62:1, 65, 73, 74, 75, 97, 100, 104, 105, 111, 116, 167, 168, 169, 182, 183, 12, 13, 14, 16, 17, 55, 63, 81, 83, 87, 126, 127, 152, 170, 172, 174, 176, 188, 198, Pigment Orange 1, 5, 13, 14, 16, 17, 24, 34, 36, 38, 40, 43, 46, 49, 51, 61, 63, 64, 71, 73, Pigment Red 1, 2, 3, 4, 5, 6, 8, 9, 12, 14, 15, 16, 17, 21, 22, 23, 31, 32, 112, 114, 146, 147, 151, 170, 184, 187, 188, 193, 210, 245, 253, 258, 266, 267, 268, 269, 37, 38, 41, 48:1, 48:2, 48:3, 48:4, 49:1, 49:2, 50:1, 52:1, 52:2, 53:1, 53:2, 57:1, 58:4, 63:1, 63:2, 64:1, 68, 171, 175, 176, 185, 208, 123, 149, 166, 178, 179, 190, 194, 224, 254, 255, 264, 270, 272, 220, 144, 166, 214, 220, 221, 242, 168, 177, 216, 122, 202, 206, 207, 209, Solvent Red 135, 179, 149, 150, 52, 207, Pigment Violet 19, 23, 29, 32, 36, 38, 42, Solvent Violet 13, 36, Pigment Brown 23, 25, and Pigment Black 1, 7. These coloring pigments, dyes, and the like are preferably added in an amount of 0.01 to 5% by mass based on the mass of the curable composition for inkjet printing of the present invention.

Also, the rutile type or anatase type titanium oxide is preferably added when the curable composition of the present invention is used as a white curable composition. In this case, such titanium oxide is preferably added in an amount of 1 to 50% by mass based on the mass of the curable composition for inkjet printing of the present invention. These coloring pigments, dyes, and the like can be used singly or in combinations of two or more.

The curable composition of the present invention is applicable to printing by an inkjet method. In order to be applicable to printing by an inkjet method, the curable composition preferably has a viscosity such that the composition can be jetted by an inkjet printer.

Viscosity refers to the viscosity measured according to JIS Z 8803. The viscosity of the curable composition for inkjet printing is preferably 50 mPa·s or less, and particularly preferably 1 to 40 mPa·s at 50°C. Within this range, the curable composition for inkjet printing can be jetted from an inkjet printer without any problem. In addition, the viscosity of the curable composition for inkjet printing of the present invention at room temperature (25°C) is preferably 150 mPa·s or less.

Accordingly, with the curable composition for inkjet printing of the present invention, a pattern can be directly drawn onto a printed wiring board substrate or the like.

The curable composition of the present invention is used as an ink in an inkjet printer and used in printing onto a substrate.

Since the curable composition of the present invention contains a photopolymerization initiator, a composition layer immediately after being printed can be photocured by irradiating the composition layer with 50 mJ/cm² to 1000 mJ/cm² of light. Light irradiation is performed by irradiation of active energy rays such as ultraviolet rays, electron beams, and actinic rays, and preferably ultraviolet rays.

For example, for a composition containing an ultraviolet photosensitive photopolymerization initiator, the composition layer can be photocured by irradiation with ultraviolet ray.

Ultraviolet irradiation in an inkjet printer can be performed by, for example, attaching a light source such as a high-pressure mercury lamp, a metal halide lamp, or an ultraviolet LED to the side surface of a print head and performing scanning by moving the print head or a substrate. In this case, printing and ultraviolet irradiation can be performed almost simultaneously.

In addition, since the curable composition of the present invention comprises a thermosetting compound, it is thermally cured by using a known heating means, e.g., a heating oven such as a hot air oven, an electric oven, or an infrared induction heating oven.

In order that the cured product obtained from the curable composition of the present invention satisfies requirements for general characteristics, the cured product is preferably cured by heating at 120°C to 170°C for 5 minutes to 60 minutes.

When the substrate is a so-called rigid substrate, i.e., a double-sided board having wiring printed on both surfaces or a multilayer board obtained by laminating substrates, a substrate having a coating film composed of the above curable composition is subjected to the above soldering process a plurality of times to be repetitively heated.

However, with the curable composition of the present invention, an obtained coating film does not produce cracks in the coating film and maintains sufficient adhesion to a substrate and coating film hardness even after undergoing a thermal history corresponding to a plurality of times of soldering, and thus has good mechanical properties expected as a solder resist to be provided on a rigid substrate.

The cured product of the curable composition of the present invention has excellent heat resistance, adhesion to a substrate, and hardness, and is thus applicable to various applications, and the application targets are not particularly limited. For example, the cured product is preferably used in a printed wiring board (rigid substrate or flexible substrate) insulating film, marking, and the like.

As described above, the present invention also provides a cured product obtained by curing the curable composition for inkjet printing of the present invention, and an electronic component having the cured product. Due to the use of the curable composition for inkjet printing of the present invention, an electronic component having high quality, durability, and reliability can be provided. In the present invention, the electronic component means a component for use in an electronic circuit, including in addition to active components such as printed wiring boards, transistors, light emitting diodes, and laser diodes, passive components such as resistors, capacitors, inductors, and connectors. The cured product of the curable composition of the present invention provides the effects of the present invention as an insulating cured coating film thereof.

The present invention is not limited to the configurations of the above embodiments and the Examples, and various modifications can be made within the scope of the invention.

### Examples

Below, the present invention will now be described by way of the Examples.

### [Examples 1 to 9, Comparative Examples 1 to 2]

### <Preparation of composition>

Components were blended in the proportions (unit: parts by mass) shown in Table 1 and stirred by a dissolver. Accordingly, the compositions of the present invention (Examples 1 to 9) and comparative compositions (Comparative Examples 1 to 2) were obtained. The obtained compositions were used to perform drawing on a substrate with an inkjet printer under the following conditions, followed by UV curing, then thermally curing at 150°C for 60 minutes, and further curing with a high-pressure mercury lamp to prepare test substrates.

Drawing conditions by an inkjet printer:
Film thicknesses: 20 µm
Apparatus: A piezoelectric inkjet printer, material printer DMP-2831 manufactured by FUJIFILM Global Graphic Systems Co., Ltd. was used (head temperature at 50°C)
UV curing conditions:
   Exposure amount: 1000 mJ/cm²
Use of UV-LED

### <Evaluation>

### (1) Inkjet (IJ) ejection property

A material printer DMP-2831 manufactured by FUJIFILM Global Graphic Systems Co., Ltd. was used to evaluate the inkjet ejection property according to the following criteria. Compositions whose droplets could be straightly, continuously, and stably ejected were given ○, and compositions whose droplets could not be stably ejected were given ×.

### (2) Resistance to cracking after reflow (heat resistance)

The temperature in a reflow oven was measured 5 times in advance by using NIS-20-82C manufactured by EIGHTECH TECTRON CO., LTD. according to the following conveyer speed and the set temperature of the heat source under the same conditions as the reflow conditions, and it was confirmed that there is no significant difference. Thereafter, the test substrates obtained above were subjected to reflow treatment by air reflow under the same conditions.
Conveyer speed: 1.0 m/min ≠ 1 zone (about 35 cm) is passed through in about 20 seconds
Set temperature of heat source: A. 210°C, B. 190°C, C. to F. 185°C, G. 265°C, H. 285°C, I. to J. cooling step by a fan

The reflow treatment was performed 5 times and the number of cracks of the cured coating film was counted.

### (3) Resistance to electroless Ni/Pd/Au plating

The test substrates obtained above were subjected to electroless nickel palladium gold plating using a commercially available electroless Ni/Pd/Au plating bath under the conditions of 3 µm of Ni, 0.075 µm of Pd, and 0.1 µm of Au.

### (3)-1 Pencil hardness

The pencil hardness of the surface of the cured coating film of the plated substrate obtained above was measured according to JIS 5600-5-4. The measurement results are shown in Table 1.

### (3)-2 Adhesion

A cross-cut peeling test according to JIS K 5600-5-6 was performed and the adhesion of the cured coating film of the plated substrate obtained above was evaluated according to the following criteria. The state of the coating film after performing the test was visually observed and judged according to the following judging criteria. Compositions that had no peeling were given ○, compositions that had slight peeling were given Δ, and compositions that had significant peeling were given ×.

**[Table 1]**

| Component | Abbreviation | Example | | | | | | | | | Comparative Example | |
|---|---|---|---|---|---|---|---|---|---|---|---|---|
| | | 1 | 2 | 3 | 4 | 5 | 6 | 7 | 8 | 9 | 1 | 2 |
| Multi-branched oligomer | 8-functional dendrimer | 2.7 | 11 | 21.9 | - | - | - | - | - | - | - | - |
| | 15-functional dendrimer | - | - | - | 2.7 | 11 | 21.9 | - | - | - | 11 | - |
| | 18-functional dendrimer | - | - | - | - | - | - | 2.7 | 11 | 21.9 | - | - |
| Photopolymerization initiator | Omnirad379 | 4.4 | 4.4 | 4.4 | 4.4 | 4.4 | 4.4 | 4.4 | 4.4 | 4.4 | 4.4 | 4.4 |
| | ITX | 0.3 | 0.3 | 0.3 | 0.3 | 0.3 | 0.3 | 0.3 | 0.3 | 0.3 | 0.3 | 0.3 |
| Bifunctional acrylate | A-BPE-4 | 21.9 | 21.9 | 21.9 | 21.9 | 21.9 | 21.9 | 21.9 | 21.9 | 21.9 | 21.9 | 21.9 |
| | HDDA | 56.9 | 48.7 | 37.7 | 56.9 | 48.7 | 37.7 | 56.9 | 48.7 | 37.7 | 48.7 | 59.6 |
| Hydroxyl group-containing acrylate | 4HBA | 3.8 | 3.8 | 3.8 | 3.8 | 3.8 | 3.8 | 3.8 | 3.8 | 3.8 | 3.8 | 3.8 |
| Thermosetting compound | BI7982 | 9.1 | 9.1 | 9.1 | 9.1 | 9.1 | 9.1 | 9.1 | 9.1 | 9.1 | - | 9.1 |
| | Melamine | 0.6 | 0.6 | 0.6 | 0.6 | 0.6 | 0.6 | 0.6 | 0.6 | 0.6 | 0.6 | 0.6 |
| Silicon-based additive | BYK-307 | 0.1 | 0.1 | 0.1 | 0.1 | 0.1 | 0.1 | 0.1 | 0.1 | 0.1 | 0.1 | 0.1 |
| IJ ejection property | | ○ | ○ | ○ | ○ | ○ | ○ | ○ | ○ | ○ | ○ | ○ |
| After 5 times of reflow | Number of cracks | 0 | 0 | 0 | 0 | 0 | 0 | 0 | 0 | 0 | >5 | >5 |
| After Ni/Pd/Au plating | Adhesion | ○ | ○ | ○ | ○ | ○ | ○ | ○ | ○ | ○ | × | Δ |
| | Pencil hardness | 3 | 3 | 4 | 4 | 4 | 5 | 4 | 4 | 4 | 2 | 2 |

Details of the components in Table 1 are as follows.
8-Functional dendrimer: Mw: 1000 to 2000, 25°C, viscosity: 200 mPa·s, product name: 6361-100 (manufactured by Eternal Materials Co., Ltd.)
15-Functional dendrimer: Mw: 3000, 25°C, viscosity: 300 mPa·s, product name: DM2015 (manufactured by Eternal Materials Co., Ltd.)
18-Functional dendrimer: Mw: 1630, 25°C, viscosity: 400 mPa·s, product name: SP1106 (manufactured by Miwon Specialty Chemical Co., Ltd.)
Omnirad 379: 2-Dimethylamino-2-(4-methyl-benzyl)-1-(4-morpholin-4-yl-phenyl)butane-1-one
ITX: Isopropylthioxanthone (manufactured by Tokyo Chemical Industry Co., Ltd.)
A-BPE-4: Ethoxylated bisphenol A diacrylate (manufactured by SHIN-NAKAMURA CHEMICAL Co., Ltd.)
HDDA: 1,6-hexanediol diacrylate (manufactured by Osaka Organic Chemical Industry Ltd.)
4-HBA: 1,4-Cyclohexane dimethanol monoacrylate (manufactured by Nihon Kasei CO., LTD)
BYK-307: Silicone-based additive (manufactured by BYK Japan KK)
BI7982: Blocked isocyanate (manufactured by Baxenden Chemicals Ltd.)

### <Evaluation results>

In Comparative Example 1 containing no blocked isocyanate (thermosetting compound), the number of cracks after 5 times of reflow exceeds 5 and the composition is inferior in heat resistance, and it was verified that the composition is also inferior in adhesion and hardness. Also, Comparative Example 2 containing no dendrimer (multi-branched oligomer) was also verified that evaluations were poor in heat resistance, adhesion, and hardness. On the other hand, in Examples 1 to 9, good results were obtained in all respects: IJ (inkjet) printability, resistance to cracking during reflow, and resistance to Ni/Pd/Au plating (adhesion and pencil hardness).

### [Examples 10 to 14, Comparative Examples 3 to 4]

Components were blended in the proportions (unit: parts by mass) shown in Table 2 and stirred by a dissolver. Thereafter, the mixtures were dispersed for 2 hours by a bead mill using 1 mm zirconia beads, and thus compositions of the present invention (Examples 10 to 14) and comparative compositions (Comparative Examples 3 to 4) were obtained. For the compositions, the characteristics tests described below were performed. The results are shown in Table 2.

### (4) Ejection property evaluation

The viscosity of the curable compositions of Examples and Comparative Examples at 25°C and 100 rpm was measured by a cone plate type viscometer (TVH-33H manufactured by Toki Sangyo Co., Ltd), and the evaluation results according to the following criteria were listed in Table 2.

| | |
|---|---|
| ○ | 150 mPa·s or less |
| × | exceed 150 mPa·s |

### (5) Warpage evaluation

The curable compositions of Examples and Comparative Examples were applied on polyimide films having a thickness of 50 µm using an applicator and these were subjected to UV exposure (high-pressure mercury lamp 500 mJ/cm²). After verifying that the coating film of the curable composition was completely cured, the laminate comprised of the polyimide film and the cured coating film was cut into pieces of 3 cm × 3 cm (height × width) to make samples (dry film thickness: 15 µm). The samples were left on a horizontal work bench with the cured coating film surface facing upward, the height of the four edges of the samples from the work bench was measured with a ruler, and then the average value of the height of the four edges was determined. The same test was performed 3 times for each sample and the average value of the 3 tests was determined. The evaluation results according to the following criteria are listed in Table 2.
⊚ The average value of the total height of the four edges is 6 mm or less
○ The average value of the total height of the four edges exceeds 6 mm and less than 10 mm
× The average value of the total height of the four edges is 10 mm or more

### (6) Pencil hardness evaluation

The curable compositions of Examples and Comparative Examples were applied on copper foil using an applicator, and these were subjected to UV exposure (high-pressure mercury lamp 500 mJ/cm²) and then subjected to heat treatment in a convection type drying oven at 150°C for 60 minutes to obtain cured coating film samples (film thickness of 25 µm). The pencil hardness of the surface of the obtained cured coating film was measured according to JIS 5600-5-4. The measurement results are shown in Table 2.

### (7) Solder heat resistance evaluation

The same cured coating film samples as used for the evaluation of the (6) pencil hardness evaluation were subjected to a heat resistance test by a solder float method according to the method of JIS C-5012. After soaking the samples in a solder bath at 260°C for 10 seconds, samples were taken out from the solder bath and left to cool, and then washed with propylene glycol monomethyl ether acetate and dried. After this test was repeated three times, the state of the coating film was visually observed, and then a cross-cut peeling test according to JIS K 5600-5-6 was performed and the adhesion of the cured coating film of the plated substrate obtained above was evaluated according to the following criteria.

The evaluation criteria are as follows.
⊚ There was no change in coating film before and after the solder heat-resistance test
○ Slight chipping was found on a cross-cut portion.
× The coating film was completely peeled off

### (8) Resistance to gold plating

The same cured coating film samples as used for (6) pencil hardness evaluation were subjected to plating under the conditions of 0.5 µm of nickel and 0.03 µm of gold and the surface state of the obtained cured coating film was observed. Thereafter, a peeling test with a cellophane adhesive tape was performed and the state of the coating film was further visually observed. The evaluation criteria are as follows.

**[Table 2]**

| | Example | | | | | Comparative Example | |
|---|---|---|---|---|---|---|---|
| | 10 | 11 | 12 | 13 | 14 | 3 | 4 |
| Titanium oxide *1 | 30 | 30 | 30 | 15 | 60 | 30 | - |
| Barium sulfate | - | - | - | - | - | - | 30 |
| Multi-branched oligomer *2 | 1 | 10 | 40 | 5 | 5 | 0 | 5 |
| Blocked isocyanate *3 | 10 | 10 | 10 | 10 | 10 | 10 | 10 |
| Acylphosphine oxide-based initiator *4 | 5 | 5 | 5 | 5 | 5 | 5 | 5 |
| Acylphosphine oxide-based initiator *5 | 2 | 2 | 2 | 2 | 2 | 2 | 2 |
| Corrosion inhibitor *6 | 1 | 1 | 1 | 1 | 1 | 1 | 1 |
| Hydroxyl group-containing acrylate *7 | 5 | 5 | 5 | 5 | 5 | 5 | 5 |
| Dioxolane ring diacrylate *8 | 14 | 14 | 14 | 14 | 14 | 14 | 14 |
| 1,9-Nonanediol diacrylate *9 | 80 | 71 | 41 | 75 | 75 | 80 | 75 |
| Melamine | 1 | 1 | 1 | 1 | 1 | 1 | 1 |
| Fluorescent brightening agents *10 | 0.15 | 0.15 | 0.15 | 0.15 | 0.15 | 0.15 | 0.15 |
| ∑ | 149 | 149 | 149 | 133 | 178 | 148 | 148 |
| Mohs hardness of filler | 6.5 | 6.5 | 6.5 | 6.5 | 6.5 | 6.5 | 3.5 |
| Warpage | ⊚ | ⊚ | ⊚ | ○ | ⊚ | ○ | × |
| Pencil hardness | 6H | 6H | 6H | 6H | 4H | 2H | 2H |
| Solder heat resistance | ⊚ | ⊚ | ○ | ○ | ○ | × | ○ |
| Resistance to gold plating | ○ | ○ | ○ | ○ | ○ | ○ | × |
| Ejection property | ○ | ○ | ○ | ○ | ○ | ○ | ○ |

| | | | | | | | |
|---|---|---|---|---|---|---|---|
| ○ No change was verified × Peeling was generated | | | | | | | |

Details of the materials in Table 2 are as follows.
*1 Rutile type titanium oxide
*2 Viscoat #1000, manufactured by OSAKA ORGANIC CHEMICAL INDUSTRY LTD.
*3 BI 7982, manufactured by Baxenden Chemicals Ltd.
*4 Omnirad TPO, manufactured by IGM Resins
*5 Omnirad 819, manufactured by IGM Resins
*6 IRGANOX 1010, manufactured by BASF Japan
*7 4HBA, manufactured by Nihon Kasei Co., Ltd.
*8 KAYARAD R-604, manufactured by Nippon Kayaku Co., Ltd.
*9 A-NOD-N, manufactured by SHIN-NAKAMURA CHEMICAL Co., Ltd.
*10 PA-100, manufactured by Showa Chemical Industry Co., LTD.

### <Evaluation results>

Moreover, the composition of the present invention comprising (D) a filler having a Mohs hardness of 5 or more was shown to be excellent in all of ejection property, low warpage, pencil hardness, solder heat resistance, and resistance to gold plating.

On the contrary, in the composition comprising no (A) multi-branched oligomer and multi-branched polymer having an ethylenically unsaturated group of the present invention (Comparative Example 3), the pencil hardness and the solder resistance were evaluated as poor, and in the composition containing a filler having a Mohs hardness of less than 5 (Comparative Example 4), warpage was generated in the coating film, the pencil hardness is low, and the resistance to gold plating was not obtained.

The present invention is not limited to the embodiments, configurations, and examples described above, and may be subjected to various modifications within the scope of the spirit of the invention.

## Claims

1. A curable composition for inkjet printing, comprising:
(A) a multi-branched oligomer or polymer having an ethylenically unsaturated group,
(B) a photopolymerization initiator, and
(C) a thermosetting compound.

2. The curable composition for inkjet printing according to claim 1, wherein the multi-branched oligomer or polymer has a hyperbranched or dendrimer structure.

3. The curable composition for inkjet printing according to claim 1 or 2, wherein the viscosity at 50°C measured according to JIS Z 8803 is 50 mPa·s or less.

4. The curable composition for inkjet printing according to any one of claims 1 to 3, further comprising (D) a filler having a Mohs hardness of 5 or more.

5. A curable composition for inkjet printing according to any one of claims 1 to 4, wherein the number of (meth)acryloyl groups of (A) a multi-branched oligomer or a multi-branched polymer having an ethylenically unsaturated group exceeds 6.

6. The curable composition for inkjet printing according to any one of claims 1 to 5, wherein (C) the thermosetting compound is blocked isocyanate.

7. A cured product obtained by curing the curable composition for inkjet printing according to any one of claims 1 to 6.

8. An electronic component comprising the cured product according to claim 7.

9. A method of producing a printed wiring board, comprising a step of drawing the curable composition for inkjet printing according to any one of claims 1 to 6 directly on a substrate with an inkjet printer; and a step of curing the curable composition for inkjet printing drawn by irradiation with light to form a resist pattern.
